(19) Europäisches Patentamt
European Patent Office
Office européen des brevets

(11) Publication number : 0 262 242 B1

# (12) EUROPEAN PATENT SPECIFICATION

(45) Date of publication of patent specification : 16.01.91 Bulletin 91/03

(51) Int. Cl.[5] : C08F 2/50, G03F 7/027

(21) Application number : 86113457.5

(22) Date of filing : 01.10.86

## (54) Photo-curable composition.

(43) Date of publication of application : 06.04.88 Bulletin 88/14

(45) Publication of the grant of the patent : 16.01.91 Bulletin 91/03

(84) Designated Contracting States : DE FR GB NL

(56) References cited :
CHEMICAL ABSTRACTS, vol. 91, no. 18, October 1979, page 67, abstract no. 142163h, Columbus, Ohio, US

(73) Proprietor : Nippon Paint Co., Ltd.
2-1-2, Oyodokita Oyodo-ku
Osaka-shi Osaka-fu (JP)

(72) Inventor : Shirota, Yasuhiko
5-7, Daikoku-cho 3-chome
Toyonaka-shi Osaka-fu (JP)
Inventor : Takimoto, Yasuyuki
19-8, Fujinosato-cho
Takatsuki-shi Osaka-fu (JP)
Inventor : Kimoto, Koichi
12-10, Higashikori 1-chome
Hirakata-shi Osaka-fu (JP)
Inventor : Kawabata, Masami
25-1, Kishibekita 4-chome
Suita-shi Osaka-fu (JP)

(74) Representative : Türk, Dietmar, Dr. rer. nat. et al
Türk, Gilie + Hrabal Patentanwälte
Brucknerstrasse 20
D-4000 Düsseldorf 13 (DE)

EP 0 262 242 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a photo-curable composition. More particularly, it relates to a photo-curable composition improved in photosensitivity which comprises a photopolymerizable monomer and a photopolymerization initiation system comprising an aromatic ketone and an amine.

In general, photo-curable compositions comprise photopolymerizable monomers and photopolymerization initiators, frequently with polymeric materials. Among various photopolymerization initiators usable in such photo-curable compositions, there is known a photopolymerization initiation system comprising an aromatic ketone and an amine. This initiation system is frequently used because of such a meritorious property that its polymerization initiation is hardly inhibited by oxygen. However, said initiation system requires the use of an amine in a large amount for sufficient photopolymerization initiation, and as the result, the hardness of the cured resin composition is not adequate so that some roughness is produced at the surface and also the resolving power is lowered.

In order to overcome said drawbacks as seen in conventional photo-curable compositions comprising an aromatic ketone and an amine as the photopolymerization initiation system, an extensive study has been made. For example in Japanese patent application 77/129512 photo curable coating compositions are described containing in aromatic ketone (benzyl) and to an amine containing one methacryloyl group.

It has now been found that the use of specific amines having two acryloyl or methacryloyl groups in said initiation system can more hardly accept the unfavorable influence of oxygen than the use of other amines and rather results in acceleration of the polymerization by oxygen. In any event, the photosensitivity of a photocurable composition is highly enhanced by the use of said specific amine in combination with an aromatic ketone so that the curing can be achieved within a shorter period of time. Advantageously, said specific amine has two acryloyl or methacryloyl groups and is itself photopolymerizable. Thus, said specific amine itself participates in photopolymerization and does not remain in its monomeric form after light exposure so that the surface characteristics of the cured resin composition is not deteriorated.

According to this invention, there is provided a photo-curable composition having a high photosensitivity which comprises a photopolymerisable monomer and as photopolymerisation initiator system, an aromatic ketone and an amine characterized in that at least a portion of said monomer and/or said amine is an amine of the formula :

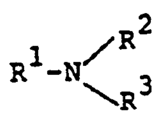

(I)

wherein $R^1$, $R^2$ and $R^3$ are each a hydrogen atom, a $(C_1$-$C_3)$ alkyl group or a group of either one of the following formulas :

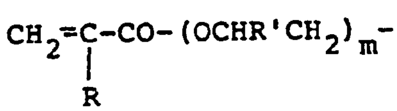 and 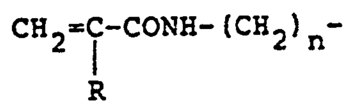

(1) (2)

wherein R and R' are each a hydrogen atom or a methyl group, m is an integer of 1 to 4 and n is an integer of 2 and 3, but two of $R^1$, $R^2$ and $R^3$ are each a group of either one of the formulas (1) and (2).

As the photopolymerizable monomer in the photocurable composition of the invention, there may be employed any one chosen from various polymerizable compounds having an ethylenic double bond, of which typical examples are methyl acrylate, ethyl acrylate, n-propyl acrylate, betahydroxyethyl acrylate, beta-hydroxypropyl acrylate, polyethylene glycol monoacrylate, polypropylene glycol monoacrylate, polyethylene glycol diacryate, polypropylene glycol diacrylate, methoxypolyethylene glycol monoacrylate, ethoxypolyethylene glycol monoacrylate, glycerol diacrylate, pentaerythritol diacrylate, trimethylolpropane triacrylate, tetramethylolmethane tetraacrylate, methyl methacrylate, ethyl methacrylate, n-propyl methacrylate, beta-hydroxyethyl methacrylate, beta-hydroxypropyl methacrylate, polyethylene glycol monomethacrylate, polypropylene glycol monomethacrylate, polyethylene glycol dimethacrylate, polypropylene glycol dimethacrylate, methoxypolyethylene glycol monomethacrylate, ethoxypolyethylene glycol monomethacrylate, glycecol dimethacrylate, pentaerythritol dimethacrylate, trimethylolpropane trimethacrylate,

tetramethylolmethane tetramethacrylate, acrylammide, N-methylolacrylamide, n-butoxymethylacrylamide, isobutoxyacrylamide, n-t-butyl acrylamide, methylenebis (acrylamide), ethylenebis(acrylamide), propylenebis (acrylamide), methacrylamide, N-methylolmethacrylamide, n-butoxymethylmethacrylamide, isobutoxymethacrylamide, n-t-butylmethacrylamide, methylenebis (methacrylammide), ethylenebis (methacrylamide), propylenebis (methacrylamide), etc. One or more of these monomers are usable in the photo-curable composition of this invention.

The photopolymerization initiation system comprises an aromatic ketone and an amine in combination. Any compound having an aromatic ring and a ketonic group within the molecule is usable as the aromatic ketone, of which examples are benzophenone, acetophenone, fluorenone, thioxanthone and anthraquinone. Further, these compounds may optionally be substituted with any substituent such as a cyano group, a nitro group, a methoxy group or a sulfonic group. One or more chosen from these aromatic ketones may be employed. As the amine, there may be used any conventional amine such as dimethanolamine, diethanolamine, and triethylamine. One or more of these amines are usable.

As stated above, it is characteristic in the photo-curable composition of the invention that at least a portion of the photopolymerizable monomer and/or the amine in the photopolymerization initiation system is an amine having a acryloyl or methacryloyl groups. In other words, said polymerizable monomers and/or said conventional amines may be partly or totally replaced by amines containing two acryloyl or methacryloyl groups. When the acryloyl or methacryloyl group-containing amine is used as one of the photopolymerizable monomers, it can simultaneously play a role as an essential component in the photopolymerization initiation system. Likewise, the acryloyl or methacryloyl group-containing amine used as an essential component in the photopolymerization initiation system can simultaneously play a role of the photopolymerizable monomer.

The acryloyl or methacryloyl group-containing amine is represented by the formula :

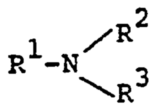

(I)

wherein $R^1$, $R^2$ and $R^3$ are each a hydrogen atom, a $C_1$-$C_3$ alkyl group (e.g. methyl, ethyl, n-propyl, isopropyl) or a group of either one of the following formulas :

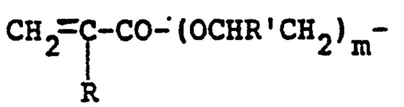

and

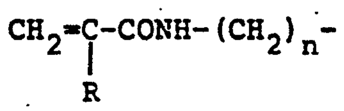

(1) (2)

wherein R and R′ are each a hydrogen atom or a methyl group, m is an integer of 1 to 4 and n is an integer of 2 and 3, but two of $R^1$, $R^2$ and $R^3$ is a group of either one of the formulas (1) and (2). Specific examples are N,N-di (acryloyloxyethyl) ethylamine, di (methacryloyloxyethyl) methylamine, N-,N-di (methacryloyloxyethyl) ethylamine, etc. Among them, particularly preferred are those of the formula (I) wherein two of $R^1$, $R^2$ and $R^3$ are either one of the formulas (1) and (2). These specific amines are per se known or may be prepared by per se known methods.

In addition to the above essential components, the photo-curable composition comprises frequently a polymeric material, of which examples are partially saponified polyvinyl acetates, cellulose derivatives, polyethylene oxide, sodium polyacrylate, polyamides, etc.

The weight proportion of (a) the photopolymerizable monomer, (b) the photopolymerization initiation system comprising the aromatic ketone and the amine and (c) the polymeric material is usually about 100: 0.001 - 10 and 0300. The molar proportion of (b-1) the aromatic ketone and (b-2) the amine in the photopolymerization initiation system is about 1 : 1 - 30. The above weight proportion as well as the molar proportion are applicable to the case wherein said monomer and/or said amine are partly or totally replaced by said acryloyl or methacryloyl group-containing amine.

When the amine in the photopolymerization initiation system is totally replaced by the acryloyl or methacryloyl group-containing amine and any other amine is not used, the weight proportion of (a) the photopolymerizable monomer, (b) the photopolymerization initiation system and (c) the polymeric material is preferred to be about 0500 (particularly 50 - 150) : 100 : 0 - 800 (particularly 20 - 400), and the molar proportion

of (b-1) the aromatic ketone and (b-2) the amine in the photopolymerization initiation system is favored to be about 1 : 5 - 500 (particularly 1 : 15 - 100).

The photo-curable composition of the invention may further comprise any conventional additives such as polymerization inhibitors (e.g. 2,6-di-t-butyl-p-cresol, hydroquinone, p-methoxyphenol) and dyestuffs (e.g. Rose Bengal, Eosine, Methylene Blue, Malachite Green).

Preparation of the photo-curable composition can be carried out by admixing the above essential and optional components, if necessary, with water or any appropriate organic solvent.

The photo-curable composition thus prepared can be used itself as a photo-curable ink or a photo-curable paint or molded into any optional shape to use as a photo-curable printing plate.

Practical and presently preferred embodiments of the invention are illustratively shown in the following Examples and Comparative Examples, wherein part(s) are by weight unless otherwise indicated.

Comparative Example 1

A photo-curable composition comprising the following materials was dried to make a photosensitive printing plate of 0.4 mm thick :

| | Part(s) |
|---|---|
| 45 % Aqueous solution of polyvinyl alcohol (saponification degree, 82 %; polymerization degree, 500) | 50 |
| N,N-Diethylaminoethyl methacrylate | 10 |
| Trimethylolpropane trimethacrylate | 10 |
| Benzophenone | 0.4 |
| Methoquinone | 0.1 |

On the photosensitive printins plate, a Kodak step tablet No. 2 (21 steps) and then a polyethylene terephthalate film were placed in order, and the resulting piled product was placed under reduced pressure to make sure their close contacts, followed by irradiation with a high pressure mercury lamp (ORC Polymer Printer 3000) of 500 mj/cm$^2$. The resulting cured plate was developed with water to remove uncured monomer. The resultant cured plate showed curing up to the 16th step.

Example 1

In the same manner as in Comparative Example 1 but using N,N-di (methacryloyloxyethyl) methylamine instead of N,N-diethylaminoethyl methacrylate, the operation was effected. The resultant cured plate showed curing up to the 18th step.

Reference Example 1

Preparation of N,N-di (methacryloyloxyethyl) methylamine :

To a 15% tetrahydrofuran solution of diethanolmethylamine (1 mol), triethylamine (2 mol) as a catalyst was added, and a 10% tetrahydrofuran solution of methacryloyl chloride (2 mol) in 10% tetrahydrofuran solution was dropwise added thereto while stirring. Since the reaction proceeded with heat generation, occasional cooling with ice was effected. After completion of the dropwise addition, the reaction mixture was further stirred for about 30 mintes, and the precipitated salt was eliminated by filtration. The filtrate was concentrated under reduced pressure, and the residue was purified by silica gel column chromatography using benzene as a developing solvent to give N,N-di (methacryloyloxyethyl) methylamine. The characteristic values in the NMR spectrum are as shown below : 4.20 (doublet) $=CH_2$ (4H) ; 5.68 (triplet) $-CH_2O$ (4H) ; 7.22 (triplet) $-NCH_2-$ (4H) ; 7.62

**Claims**

1. A photo-curable composition having a high photosensitivity which comprises a photopolymerizable monomer and, as a photopolymerization initiatiation system, an aromatic ketone and an amine, characterized in that at least a portion of said monomer and/or said amine is an amine of the formula :

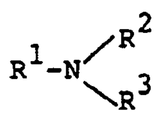

(I)

wherein $R^1$, $R^2$ and $R^3$ are each hydrogen atom, a ($C_1$-$C_3$) alkyl group or a group of either one of the following formulas :

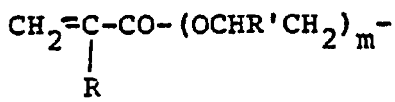 and 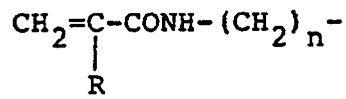

(1) (2)

wherein R and R' are each a hydrogen atom or a methyl group, m is an integer of 1 to 4 and n is an integer of 2 and 3, but two of $R^1$, $R^2$ and $R^3$ are each a group of either one of the formulas (1) and (2).

2. The composition according to claim 1, which comprises further a polymeric material.

3. The composition according to claim 1, wherein the amine in the photopolymerization initiation system is totally replaced by the acryloyl or methacryloyl group-containing amine.

4. The composition according to claim 1, wherein the weight proportion of the monomer and the photopolymerization initiation system is 100 : 0.001 - 10.

5. The composition according to claim 4, wherein the molar proportion of the aromatic ketone and the amine in the photopolymerization initiation system is 1 : 1 - 30.

6. The composition according to claim 1, wherein the weight proportion of the monomer and the photopolymerization initiation system is 0 - 500 : 100.

7. The composition according to claim 6, wherein the molar proportion of the aromatic ketone and the amine in the photopolymerization initiation system is 1 : 5 - 500.

8. The composition according to claim 1 wherein the amine according to formula I is N,N-di (methacryloyloxy ($C_1$-$C_3$) alkyl) ($C_1$-$C_3$) alkylamine.

9. The composition according to claim 1 wherein the amine according to formula I is N,N-di (methacryloyloxyethyl) methylamine.

10. The composition according to claim 1 wherein the amine according to formula I is N,N-di (methacryloyloxyethyl) ethylamine.

**Ansprüche**

1. Photohärtbare Zusammensetzung mit einer hohen Photoempfindlichkeit, welche ein photopolymerisierbares Monomer umfaßt und als ein Photopolymerisationsinitiatorsystem ein aromatisches Keton und ein Amin, die dadurch gekennzeichnet ist, daß mindestens ein Teil des Monomeren und/ oder des Amins ein Amin ist der Formel :

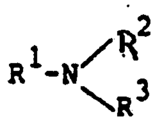

(I)

worin $R^1$, $R^2$ und $R^3$ jeweils ein Wasserstoffatom, eine ($C_1$-$C_3$)Alkylgruppe oder eine der beiden Gruppen der folgenden Formeln sind

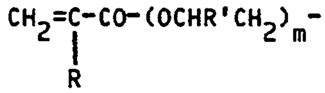 und 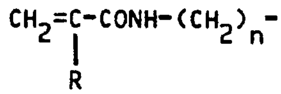

(1) (2)

worin R und R' jeweils ein Wasserstoffatom oder eine Methylgruppe sind, m eine ganze Zahl von 1 bis 4 ist und n eine ganze Zahl von 2 und 3 ist, zwei von $R^1$, $R^2$ und $R^3$ sind aber jeweils eine der beiden Gruppen der Formel (1) und (2).

2. Zusammensetzung nach Anspruch 1, welche ferner ein Polymermaterial umfaßt.

3. Zusammensetzung nach Anspruch 1, worin das Amin im Photopolymerisationsinitiatorsystem vollständig durch das die Acryloyloder Methacryloylgruppe enthaltende Amin ersetzt wird.

4. Zusammensetzung nach Anspruch 1, worin das Gewichtsverhältnis des Monomeren und des Photopolymerisationinitiatorsystems 100 : 0,001 - 10 beträgt.

5. Zusammensetzung nach Anspruch 4, worin das molare Verhältnis des aromatischen Ketons und des Amins in dem Photopolymerisationsinitiatorsystem 1 : 1 - 30 beträgt.

6. Zusammensetzung nach Anspruch 1, worin das Gewichtsverhältnis des Monomeren und des Photopolymerisationsinitiatorsystems 0 - 500 : 100 beträgt.

7. Zusammensetzung nach Anspruch 6, worin das molare Verhältnis des aromatischen Ketons und des Amins im Photopolymerisationsinitiatorsystem 1 : 5 - 500 beträgt.

8. Zusammensetzung nach Anspruch 1, worin das Amin der Formel I N,N-Di (methacryloyloxy ($C_1$-$C_3$) alkyl)-($C_1$-$C_3$) alkylamin ist.

9. Zusammensetzung nach Anspruch 1, worin das Amin der Formel I N,N-Di (methacryloyloxyethyl) methylamin ist.

10. Zusammensetzung nach Anspruch 1, worin das Amin der Formel I N,N-Di (methacryloyloxyethyl) ethylamin ist.

## Revendications

1. Composition photodurcissable ayant une photosensibilité élevée qui comprend un monomère photopolymérisable et, comme système d'induction de photopolymérisation, une cétone aromatique et une amine, caractérisée en ce qu'au moins une partie dudit monomère et/ou de ladite amine est une amine de formule :

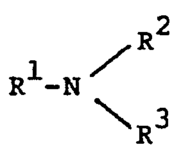 (I)

dans laquelle $R^1$, $R^2$ et $R^3$ représentent chacun un atome d'hydrogène, un groupe alcoyle en $C_1$ à $C_3$ ou un groupe de l'une quelconque des formules suivantes :

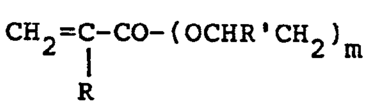 et 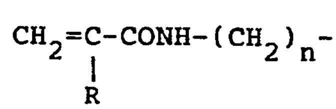

(1) (2)

dans lesquelles R et R' représentent chacun un atome d'hydrogène ou un groupe méthyle, m est un nombre entier valant de 1 à 4 et n est un nombre entier valant 2 ou 3, mais deux des radicaux $R^1$, $R^2$ et $R^3$ représentent l'un et l'autre un groupe de l'une ou l'autre des formules (1) et (2).

2. Composition selon la revendication 1, qui comprend en outre une matière polymérique.

3. Composition selon la revendication 1, dans laquelle l'amine dans le système d'induction de photopolymérisation est totalement remplacée par l'amine contenant le groupe acryloyle ou méthacryloyle.

4. Composition selon la revendication 1, dans laquelle la proportion pondérale du monomère et du système d'induction de photopolymérisation est de 100 : 0,001 - 10.

5. Composition selon la revendication 4, dans laquelle la proportion molaire de la cétone aromatique et de l'amine dans le système d'induction de photopolymérisation est de 1 : 1 - 30.

6. Composition selon la revendication 1, dans laquelle la proportion pondérale du monomère et du système d'induction de photopolymérisation est de 0 - 500 : 100.

7. Composition selon la revendication 6, dans laquelle la proportion molaire de la cétone aromatique et de l'amine dans le système d'induction de photopolymérisation est de 1 : 5 - 500.

8. Composition selon la revendication 1 dans laquelle l'amine selon la formule I est une N,N-di (méthacryloyloxy (alcoyle en $C_1$ à $C_3$)-(alcoylamine en $C_1$ à $C_3$).

9. Composition selon la revendication 1 dans laquelle l'amine selon la formule I est la N,N-di (méthacryloyloxyéthyl) méthylamine.

10. Composition selon la revendication 1 dans laquelle l'amine selon la formule I est la N,N-di (méthacryloyloxyéthyl) éthylamine.